Europäisches Patentamt

European Patent Office

Office européen des brevets

(11) Publication number: **0 445 680 A2**

# EUROPEAN PATENT APPLICATION

(21) Application number: 91103183.9

(22) Date of filing: 04.03.91

(51) Int. Cl.5: **G03F 7/023**

(30) Priority: 05.03.90 JP 53335/90

(43) Date of publication of application:
**11.09.91 Bulletin 91/37**

(84) Designated Contracting States:
**DE GB**

(71) Applicant: FUJI PHOTO FILM CO., LTD.
210 Nakanuma Minami Ashigara-shi
Kanagawa(JP)

(72) Inventor: Tan, Shiro, c/o Fuji Photo Film Co.,
Ltd.
4000, Kawajiri, Yoshida-cho
Haibara-gun, Shizuoka(JP)
Inventor: Kokubo, Tadayoshi, c/o Fuji Photo
Film Co., Ltd.
4000, Kawajiri, Yoshida-cho
Haibara-gun, Shizuoka(JP)
Inventor: Inno, Toshifumi, c/o Fuji Photo Film
Co., Ltd.
4000, Kawajiri, Yoshida-cho
Haibara-gun, Shizuoka(JP)

(74) Representative: Barz, Peter, Dr. et al
Patentanwälte Dipl.-Ing. G. Dannenberg Dr.
P. Weinhold, Dr. D. Gudel Dipl.-Ing. S.
Schubert, Dr. P. Barz Siegfriedstrasse 8
W-8000 München 40(DE)

(54) Positive type photoresist composition.

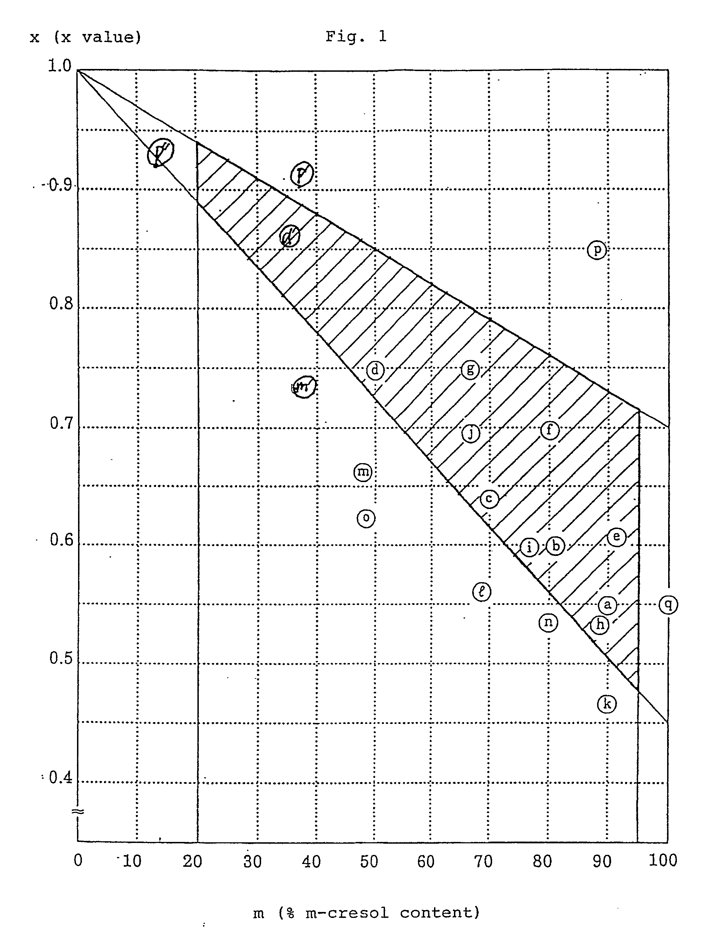

(57) A positive type photoresist composition which is superior in the prevention of pattern break and scumming during development, comprising an alkali-soluble novolak resin and a 1,2-quinonediazide compound, wherein said novolak resin is a condensate of a mixture of m-cresol and p-cresol with at least one of formaldehyde, formaldehyde polymer and formaldehyde precursor and wherein the relationship between $X = A/(A + B + C)$ and the content of m-cresol in said novolak resin falls within the shaded part (including the straight lines surrounding this part) in Figure 1, said A representing an integrated value of peak area between 23.0 ppm and 31.0 ppm , B representing an integrated value of peak area between 31.0 ppm and 34.0 ppm and C representing an integrated value of peak area between 34.0 ppm and 37.0 ppm in a $^{13}$C-NMR spectrum of a dimethyl sulfoxide-d$_6$ solution of said novolak resin.

EP 0 445 680 A2

The present invention relates to a positive type photoresist composition which consists of a specific alkali-soluble novolak resin and a 1,2-quinonediazide compound and is sensitive to radiation such as ultraviolet rays, far ultraviolet rays, X-rays, electron rays, molecular beam, $\gamma$-rays and synchrotron orbital radiation. More particularly, the present invention relates to a photoresist composition for fine work which provides excellent resolution and sensitivity and is not subject to microscopic defects due to scum developed upon development or foaming upon exposure.

The positive type photoresist of the present invention is coated on a substrate such as semiconducting wafer, glass, ceramics and metal by a spin coating method or roller coating method to a thickness of 0.5 to 3 $\mu$m. The coat material is then heated and dried. A circuit pattern or the like is formed in the material through an exposure mask by the irradiation with ultraviolet rays. The material is then subjected to development to obtain a positive image. Subsequently, the positive image is used as mask to effect patterned etching on a substrate. Typical applications of positive type photoresist are production of semiconductors such as IC, production of circuit board such as liquid crystal and thermal head, and photofabrication.

As positive type photoresist compositions there are normally used compositions comprising an alkali-soluble resin and a naphthoquinonediazide compound as the light-sensitive material. Examples of such compositions include novolak type phenol resin/naphthoquinonediazide-substituted compounds as disclosed in U.S. Patents 3,666,473, 4,115,128 and 4,173,470. Most typical examples of such compositions include novolak resin made of cresol-formaldehyde/trihydroxybenzophenone-1,2-naphthoquinonediazidesulfonic ester as disclosed in L.F. Thompson, Introduction to Microlithography, ACS, No. 219, pages 112 to 121.

As a binder, novolak resin can be dissolved in an alkaline aqueous solution without swelling. The novolak resin can also exhibit a high resistance particularly to plasma etching when an image thus produced is used as a mask for etching. Thus, novolak resin is particularly useful in this application. As a light-sensitive material, a naphthoquinonediazide compound itself serves as a dissolution inhibitor for reducing the alkali solubility of novolak resin but is peculiar in that it undergoes decomposition upon the irradiation with light to produce an alkali-soluble substance which rather enhances the alkali solubility of novolak resin. Because of the great change in properties by the irradiation with light, naphthoquinonediazide compound is particularly useful as a light-sensitive material for a positive type photoresist.

From such a perspective, many positive type photoresists comprising novolak resin and naphthoquinonediazide light-sensitive material have heretofore been developed and put into practical use. These positive type photoresists have attained sufficient results in practice with lines of a width of as small as 1.5 to 2 $\mu$m.

However, integrated circuits have added to their degree of integration. It is a recent tendency that the formation of ultrafine patterns formed of lines of a width of 1 $\mu$m or less is required in the production of a semiconducting substrate such as SLSI (Super Large Scale Integration). In such an application, a photoresist having a high resolution, a high accuracy of reproduction of exposure mask pattern and a high sensitivity for high productivity has been desired.

In particular, it has been said that a resist having a high $\gamma$ value can be advantageously used to enhance the resolution. Thus, researches have been made to develop a resist composition which gives a high $\gamma$ value. The $\gamma$ value is a measure to determine how the solubility of resist films changes depending on exposure. It is said that resist films showing a more rapid change in solubility can provide resists having a higher resolution.

An extremely large number of patents and reports disclosing such a technique have been published. With respect to novolak resin as a main component of a positive type photoresist, many patent applications have been filed based on the monomer component, distribution of molecular weight, the synthesis method, etc. Similarly, many techniques for providing a high $\gamma$ value have been disclosed on quinonediazide light-sensitive material, development technique, etc.

However, since the degree of integration in semiconductor devices seems to show a yearly increase, it has been desired to provide a higher resolution in the lithographic process which is a main step in the circuit printing process.

Nevertheless, the high resolution resists have been recently found to have a common disadvantage in that when exposed to light, they often undergo fine foaming which can cause fine defects such as pattern break. It is uncertain why such fine defects occur. Since the main component of the foam is nitrogen, it can be proposed that the quinonediazide light-sensitive material undergoes decomposition upon exposure to produce nitrogen which then forms bubbles without escaping to the atmosphere through the resist film for some reason. The prevention of fine defects is commercially important. However, the relationship between the prevention of fine defects and the fine structure of m/p-cresol novolak resins has not been discovered.

The recent high resolution resist experiences a further problem in that it often suffers from scumming (poor clearing) between pattern lines during development. The scum causes breaks or shorts in the circuit pattern and, therefore, must be totally removed.

It has thus been desired to provide a resist which is suitable for the formation of such a fine pattern, excellent in sensitivity and resolution and is less subject to pattern break due to fine foaming or fine defects due to scum.

It is therefore an object of the present invention to provide a positive type photoresist composition having a high resolution which is less subject to pattern defects due to fine foaming upon exposure in the production of semiconductor devices.

It is another object of the present invention to provide a positive type photoresist composition having a high resolution which is less subject to fine defects due to scum during development.

The above and other objects of the present invention will become more apparent from the following detailed description and examples.

The inventors made extensive studies paying attention to these problems. As a result, the inventors found that these objects of the present invention can be accomplished with a positive type light-sensitive resin composition comprising a quinonediazide compound and an alkali-soluble novolak resin wherein said novolak resin is a novolak resin obtained by co-condensation of m-cresol and p-cresol with at least one of formaldehyde, formaldehyde polymer and formaldehyde precursor and meets requirements for its microstructure specified by peak area ratio determined by $^{13}$C-NMR, which is a well known technique. See, for example, Kirk-Othmer, Encyclopedia of Science and Technology, 3rd Ed., 1981, Vol. 17, pages 400 and 401.

In particular, these objects of the present invention can be accomplished with a positive type photoresist composition comprising a quinonediazide compound and an alkali-soluble novolak resin, characterized in that the relationship between X = A/(A + B + C) and the content of m-cresol in said novolak resin falls within the shaded part (including the solid lines surrounding this part) in Figure 1, and wherein A represents an integrated value of peak area between 23.0 ppm and 31.0 ppm, B represents an integrated value of peak area between 31.0 ppm and 34.0 ppm and C represents an integrated value of peak area between 34.0 ppm and 37.0 ppm in $^{13}$C-NMR spectrum of a dimethyl sulfoxide-d$_6$ solution of said novolak resin.

All the peaks in $^{13}$C-NMR spectrum as specified herein should be attributed to the methylene bond of the cresol rings. The peak ratio and X value are construed as corresponding to specific manner in which two same or different cresol rings are arranged and bonded to each other.

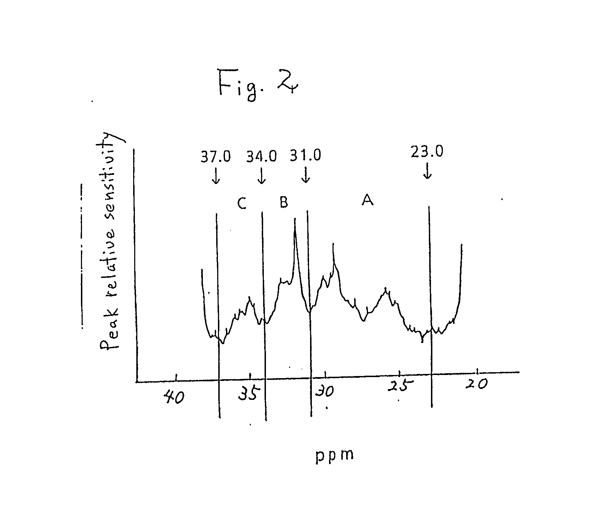

In practice, however, as exemplified by the spectrum in Figure 2, when a novolak resin comprising a mixture of m-cresol and p-cresol is spectrally observed, this portion exhibits a wide range of spectrum comprising a mixture of many peaks. Therefore, each of these peaks cannot be definitively attributed. Furthermore, the above specified X value involves various ways of bonding. However, it can be believed that the X value is related to the ratio of cresol rings bonded to each other in the ortho-position.

For example, the X value of a novolak resin comprising a mixture of m-cresol and p-cresol prepared by the prior art synthesis method as disclosed in JP-A-58-17112 (the term "JP-A" as used herein refers to a "published unexamined Japanese patent application") lies under the shaded part in Figure 1.

However, the inventors discovered that a photoresist prepared from a novolak resin comprising a mixture of m-cresol and p-cresol such that the X value falls within the above specified range with respect to the content of m-cresol in the novolak resin is less subject to defects due to fine foaming and scum during development than the prior art photoresist without exception while at the same time having high resolution regardless of its preparation method. Thus, the present invention was achieved.

Heretofore, it has not been known which properties of novolak resin are related to the above mentioned fine foaming or scum. Furthermore, no clues have been found which would lead one to predict the relationship between the microstructure as defined above and the foaming and scum properties of novolak resin.

That is, to date, some references have discussed the relationship between the microstructure of novolak resin and the properties, particularly resolution or $\gamma$ value thereof as resist.

JP-A-59-162542 discloses that a novolak resin comprising m-cresol wherein the peak ratio similarly determined by $^{13}$C-NMR falls within a specified range (N = (d/(a + b + c)) is 0.15 or more wherein a, b, c and d represent peaks of $^{13}$C-NMR based on =CH- in each position of m-cresol, i.e., about 112.5 ppm, about 115.5 ppm, about 116.7 ppm, and about 119.6 ppm, respectively) can provide a high $\gamma$ value.

Similarly, SPIE, Collection of Papers on Microlithography Symposium, Vol. 631, pages 76 to 82, 1986, discloses that the higher the non-bonding ratio in the 4-position of an m-cresol novolak (defined as S4 value; determined by dividing the area of $^{13}$C-NMR signal of =CH-in the 4-position by that in the 5-position) is, the higher is $\gamma$ value. S4 value also serves as a parameter representing the degree of bonding of m-cresol rings in the ortho position.

These references can be considered to discuss the relationship between the manner of bonding in novolak and the properties of resist. However, these references would not permit one to predict the fact that a novolak obtained by condensation of formaldehyde and a mixture of m-cresol and p-cresol having a specific structure as disclosed in the present invention can advantageously serve as a positive type photoresist.

Since the relationship between the peak ratio and the properties of resist as described in JP-A-59-162542 is based on m-cresol novolak and the peaks are differently attributed in a novolak resin comprising a mixture of m-cresol and p-cresol, the above mentioned relationship cannot be similarly established. Furthermore, these references give no suggestions for elimination of fine defects such as fine foaming and scum.

It is proved in the latter reference that the relationship between S4 value and properties is attributed to the fact that the more the 4-position of m-cresol is unsubstituted, the easier it is for the coupling reaction thereof with the light-sensitive material to occur. Therefore, the reference can be understood to suggest that the more m-cresol which can render the 4-position vacant occurs, the better are attained the results. However, it can be concluded that since the use of a novolak resin obtained by co-condensation of m-cresol with p-cresol leads to a reduction in the vacancy of the 4-position, undesirable results are given. Therefore, the reference can be considered to be totally different from the present invention and gives no suggestions for elimination of fine foaming and scum.

On the other hand, JP-A-62-35349 and JP-A-62-270951 disclose that the higher the proportion of p-cresol in a novolak resin comprising a mixture of m-cresol and p-cresol is, the higher is the resolution of the resist prepared therefrom. However, neither of the two patents suggests the relationship between the proportion of specific manners of bonding and the properties of a resist involving in the occurrence of fine defects in m/p-cresol novolak and the present invention. As proved in Examples of the present invention, the X value of an m/p-cresol novolak prepared according to the above cited patents does not fall within the range specified in the present invention.

By way of example and to make the description more clear, reference is made to the accompanying drawings in which:

Figure 1 illustrates the relationship between the X value and the m-cresol content in the novolak resin as specified in the present invention wherein the range claimed in the present claim and the position of various m/p-cresol novolaks are shown with the X value on the ordinate axis and % m-cresol content on the abscissa axis (novolaks which fall within the shaded part, including the surrounding straight lines, can be advantageously used in the present invention); and

Figure 2 illustrates an example of the signal in the zone from 23.0 to 37.0 ppm observed by $^{13}$C-NMR on a typical m/p-cresol novolak resin and peaks A to C on the signal as specified in the present invention.

The present invention will be further described hereinafter.

The m/p-cresol novolak resin to be used in the present invention is substantially obtained by co-condensation of m-cresol and p-cresol as monomers with formaldehyde.

With respect to the proportion of the two monomer components, the content of m-cresol in the polymer is in the range of 20 to 95%, preferably 40 to 85%, more preferably 40 to 75%, based on the total of m-cresol and p-cresol.

The content of m-cresol in the m/p-cresol novolak resin can be analytically determined by, e.g., the peak ratio of $-CH_3$ group determined by $^{13}$C-NMR. (For example, assuming that the peak of 20.4 ppm is derived from p-cresol and the peaks of 15.6 ppm, 19.1 ppm and 19.5 ppm are all derived from m-cresol, a calibration curve is drawn on the area ratio of these peaks to determine this value.)

The charge ratio of the two monomer components in condensation does not necessarily conform with the proportions of m-cresol and p-cresol in the polymer. Therefore, the above specified range is not directly applied to the charge ratio of the two monomer components.

If the m-cresol content is too low, the sensitivity thus obtained is too low for practical use. On the contrary, if the m-cresol content is too high, the defocus latitude is narrow and scum easily occurs.

The present invention provides a positive type photoresist composition comprising a novolak resin prepared in the manner as described above, characterized in that the relationship between $X = A(A + B + C)$ and the content of m-cresol in said novolak resin falls within the shaded part (including the border line surrounding this part) in Figure 1 wherein A represents an integrated value of peak area between 23.0 ppm and 31.0 ppm, B represents an integrated value of peak area between 31.0 ppm and 34.0 ppm and C represents an integrated value of peak area between 34.0 ppm and 37.0 ppm in $^{13}$C-NMR spectrum of a dimethyl sulfoxide-d$_6$ solution of said novolak resin.

In particular, the above specified range is a zone bordered by four straight lines, i.e., $x = 1 - 0.3 \, m/100$,

x = 1 - 0.55 m/100, m = 20 and m = 95 wherein x represents the X value and m represents the % m-cresol content (including the four straight lines).

The $^{13}$C-NMR measurement was conducted in the following manner:

Reverse gated decoupling method (non-NOE decoupling) was applied with the use of a Fourier transformation nuclear magnetic resonance apparatus Model AC-250 (resonance frequency: 62.896 MHz, available from Bullcar) under the conditions of temperature of 24 to 26° C, a pulse width of 9 $\mu$s (about 80 degree), a waiting period of 40 sec., a measurement frequency width of 18,000 Hz, a data point number of 16 K, an integration time of 1,000 or more, and a reference of 0.0 ppm for tetramethyl silane.

The formaldehyde to be used in the condensation of the above mentioned cresols is normally used in the form of a formalin solution. However, the formaldehyde may be used in the form of formaldehyde precursor such as trioxane and formaldehyde polymer (e.g., paraformaldehyde) or in a form obtained by previously methylolating a cresol monomer or its oligomer.

The preparation of the novolak resin according to the present invention can be accomplished by various methods.

For example, m-cresol and p-cresol are mixed in a predetermined proportion. Formalin solution is then added to the mixture. The reaction system is subjected to condensation with triethylamine. In this condensation process, the added amount of a catalyst can be appropriately altered to obtain a novolak resin with an X value which falls within the above specified range.

Alternatively, the monomer components and paraformaldehyde are dissolved in a nonpolar solvent such as toluene. The resulting solution is then heated under pressure to obtain a novolak resin which tends to exhibit a high X value as described by G. Casiraghi, et al., in Makromol. Chem., 182, 2973-2979.

Furthermore, the mixture of m-cresol and p-cresol can be subjected to condensation in the presence of a reaction catalyst such as a salt of divalent metal as disclosed in JP-A-59-162542 and JP-A-60-159846 to prepare a novolak resin with a high X value.

All these preparation methods correspond to those known as methods for the synthesis of high ortho novolak. Therefore, besides the above mentioned synthesis methods, all these methods for the synthesis of high ortho novolak can be applied as desirable methods for the preparation of a novolak with a high X value.

The X value is considered to be an index to express the proportion of high ortho bonding. Therefore, novolak resins synthesized in accordance with a method of preparing a high ortho novolak resin have a high X value. When the X value is too high, the resist performances are deteriorated with respect to the sensitivity and scum. A novolak resin prepared using only pure p-cresol as a cresol component has an X value of 100% and this X value is lowered as the amount of comonomer m-cresol increases. If the copolymerization reaction is carried out in an appropriate process, the lowered X value is heightened to some extent. It has unexpectedly been found that novolak resins having such heightened X value have properties to prevent foaming and scum.

The weight average molecular weight of the novolak resin thus obtained as determined by gel permeation chromatography (GPC) is preferably in the range of 1,000 to 30,000 as calculated in terms of polystyrene. If this value falls below 1,000, the unexposed portions show a great reduction in the film thickness after development. If this value exceeds 30,000, the sensitivity shows a remarkable drop. A particularly preferred range is from 2,000 to 15,000.

In the novolak resin of the present invention, the resin obtained by condensation reaction can be fractionated, and its molecular weight distribution can be controlled before use.

In particular, if low molecular components such as dimers are removed to an extent such that the content of dimer component falls below 15% by weight of the novolak resin, the novolak resin thus obtained advantageously provides improvements particularly in developability and heat resistance. In order to control the dimer content, a novolak resin prepared according to the ordinary method can be dissolved in a polar solvent such as methanol, ethanol, acetone, methyl ethyl ketone, dioxane and tetrahydrofuran, and then added to a mixture of water and a polar solvent to precipitate the resin component. In another method, after a predetermined period of synthesis reaction of an alkali-soluble resin, water, unreacted monomers, formaldehyde, etc., are distilled off at a temperature of 230° C or higher, preferably 250° C or higher under a pressure of 10 mm Hg or lower instead of being distilled off at a temperature of 150° C to 200° C under reduced pressure as effected in the ordinary method. In this method, the dimer component can be efficiently removed.

Examples of 1,2-naphthoquinonediazide compound which can be used in the present invention include an ester of 1,2-naphthoquinonediazide-5-sulfonic acid, 1,2-naphthoquinonediazide-4-sulfonic acid or 1,2-benzoquinonediazide-4-sulfonic acid with a polyhydroxy aromatic compound.

Examples of such a polyhydroxy aromatic compound include polyhydroxybenzophenones such as

EP 0 445 680 A2

2,3,4-trihydroxybenzophenone, 2,4,4'-trihydroxybenzophenone, 2,4,6-trihydroxybenzophenone, 2,3,4,4'-tetrahydroxybenzophenone, 2,2',4,4'-tetrahydroxybenzophenone, 2,4,6,3',4',5'-hexahydroxybenzophenone, and 2,3,4,3',4',5'-hexahydroxybenzophenone; polyhydroxyphenylalkylketones such as 2,3,4-trihydroxyacetophenone and 2,3,4-trihydroxyphenylhexylketone; bis[(poly) hydroxyphenyl]alkanes such as bis(2,4-dihydroxyphenyl)methane, bis(2,3,4-trihydroxyphenyl)methane, and bis(2,4-dihydroxyphenyl)propane-1; polyhydroxybenzoic esters such as propyl 3,4,5-trihydroxybenzoate and phenyl 3,4,5-trihydroxybenzoate; bis(polyhydroxybenzoyl)alkanes or bis(polyhydroxybenzoyl)aryls such as bis(2,3,4-trihydroxybenzoyl)-methane and bis(2,3,4-trihydroxybenzoyl)benzene; alkylene-di(polyhydroxybenzoate) such as ethylene glycol-di(3,5-dihydroxybenzoate); polyhydroxybiphenyls such as 3,5,3',5'-biphenyltetrol, 2,4,2',4'-biphenyltetrol, 2,4,6,3',5'-biphenylpentol, and 2,4,6,2',4',6'-biphenylhexol; polyhydroxytriphenylmethanes such as 4,4',3'',4''-tetrahydroxy-3,5,3',5'-tetramethyltriphenyl methane, 4,4',2'',3'',4''-pentahydroxy-3,5,3',5'-tetramethyltriphenylmethane, and 2,3,4,2',3',4',3'',4''-octahydroxy-5,5'-diacetyltriphenylmethane; polyhydroxyspirobi-indanes such as 3,3,3',3'-tetramethyl-1,1'-spirobi-indane-5,6,5',6'-tetrol, 3,3,3',3'-tetramethyl-1,1'-spirobi-indane-5,6,7,5',6',7'-hexol, 3,3,3',3'-tetramethyl-1,1'-spirobi-indane-4,5,6,-4',5',6'-hexol and 3,3,3',3'-tetramethyl-1,1'-spirobi-indane-4,5,6,5',6',7'-hexol; polyhydroxy phthalides such as 3,3-bis(3,4-dihydroxyphenyl)phthalide, 3,3-bis(2,3,4-trihydroxyphenyl)phthalide, and 3',4',5',6'-tetrahydroxyspiro-[phthalide-3,9'-xanthene]; polyhydroxybenzopyrans such as 2-(3,4-dihydroxyphenyl)-3,5,7-trihydroxybenzopyran, 2-(3,4,5-trihydroxyphenyl)-3,5,7-trihydroxybenzopyran, 2-(3,4-dihydroxyphenyl)-3-(3,4,5-trihydroxybenzoyloxy)-5,7-dihydroxybenzopyran, and 2-(3,4,5-trihydroxyphenyl)-3-(3,4,5-trihydroxybenzoyloxy)-5,7-dihydroxybenzopyran; polyhydroxyphenyl chromans such as 2,4,4-trimethyl-2-(2',4'-dihydroxyphenyl)-7-hydroxychroman, 2,4,4-trimethyl-2-(2',3',4'-trihydroxyphenyl)-7,8-dihydroxychroman, and 2,4,4-trimethyl-2-(2',4',6'-trihydroxyphenyl)-5,7-dihydroxychroman; hydroxybenzylphenols such as 2,6-bis(2,3,4-trihydroxybenzyl)-4-methylphenol, 2,6-bis(2,4-dihydroxybenzyl)-4-methylphenol, 2,6-bis(5-chloro-2,4-dihydroxybenzyl)-4-methylphenol, 2,6-bis(2-hydroxybenzyl)-4-methylphenol, 2,6-bis(2,4,6-trihydroxybenzyl)-4-methylphenol, 2,6-bis(2-acetyl-3,4,5-trihydroxybenzyl)-4-methylphenol, 2,4,6-tris(2,3,4-trihydroxybenzyl)phenol, 2,6-bis(3,5-dimethyl-4-hydroxybenzyl)-4-methylphenol, 2,4,6-tris(3,5-dimethyl-4-hydroxybenzyl)-4-methylphenol, 4,6-bis(3,5-dimethyl-4-hydroxybenzyl)pyrogallol, 2,6-bis(3,5-dimethyl-4-hydroxybenzyl)-4-methylphenol, and 2,6-bis(3,5-dimethyl-4-hydroxybenzyl)phloroglucinol; flavono dyes such as quercetin and rutin, oligomers of novolak, and analogs thereof.

Furthermore, an acetone-pyrogallol condensation resin or a polymer containing an aromatic hydroxyl group such as polyvinlyphenol can be used in stead of these low molecular compounds. The hydroxyl group in the novolak prepared according to the present invention may be substituted by quinonediazide in a suitable amount so that the novolak can also serve as a light-sensitive material or binder.

The proportion of the light-sensitive material to the alkali-soluble novolak resin is in the range of 5 to 50 parts by weight, preferably 10 to 30 parts by weight, per 100 parts by weight of novolak resin. If this value falls below 5 parts by weight, the percent film remaining is remarkably lowered. If this value exceeds 50 parts by weight, the sensitivity and the solubility in a solvent are lowered.

The composition of the present invention can further comprise a polyhydroxy compound in order to accelerate the solubility in the developer, adjust the sensitivity and improve other properties.

For such a purpose, any of the polyhydroxy compounds previously exemplified as skeleton compounds for light-sensitive material can be used. However, when such a polyhydroxy compound is used to attain an ordinary range of solubility accelerating effect, it can often cause sensitization and reduction in the film thickness at the same time. Therefore, the alkali solubility of the polyhydroxy compound should be selected depending on the overall composition of the resist to minimize these difficulties.

Examples of solvent in which the present light-sensitive material and alkali-soluble novolak resin can be dissolved include ketones such as methyl ethyl ketone and cyclohexanone; ethers such as ethylene glycol monomethyl ether, ethylene glycol monoethyl ether, dioxane and ethylene glycol dimethyl ether; cellosolve esters such as methyl cellosolve acetate and ethyl cellosolve acetate; aliphatic esters such as butyl acetate, methyl lactate and ethyl lactate; halogenated hydrocarbons such as 1,1,2-trichloroethylene; and highly polar solvents such as dimethyl acetamide, N-methylpyrrolidone, dimethylformamide and dimethyl sulfoxide. These solvents can be used singly or in admixture.

The positive type photoresist composition of the present invention can comprise a dye, a plasticizer, an adhesive, a surface active agent, etc., as desired. Specific examples of such additives include dyes such as methyl violet, crystal violet and malachite green; plasticizers such as stearic acid, acetal resin, phenoxy resin, alkyd resin and epoxy resin; adhesion aids such as hexamethyl disilazalane and chloromethyl silane; and surface active agents such as nonylphenoxypoly(ethyleneoxy)ethanol and octylphenoxypoly-(ethyleneoxy)ethanol.

Particularly preferred among these dyes are those containing in their molecule an alkali-soluble group such as an aromatic hydroxyl group or a carboxylic group, such as curcumin.

The above mentioned positive type photoresist composition can be coated by a proper coating means such as a spinner or a coater on a substrate as commonly used in the production of precision integrated circuit elements (e.g., silicon/silicon dioxide-coated substrate), exposed to light through a predetermined mask, and then developed to obtain an excellent resist. For the purpose of improving coating properties, the positive type photoresist composition of the present invention may preferably comprise a surface active agent containing a fluorine-substituted group, silicon-containing group, etc., to lower its surface tension.

Examples of the developer which can be used to develop the positive type photoresist composition of the present invention include alkaline aqueous solutions such as inorganio akalies (e.g., sodium hydroxide, potassium hydroxide, sodium carbonate, sodium silicate, sodium metasilicate, aqueous ammonia), primary amines (e.g., ethylamine, n-propylamine), secondary amines (e.g., diethylamine, di-n-butylamine), tertiary amines (e.g., triethylamine, methyldiethylamine), alcoholamines (e.g., dimethylethanolamine, triethanolamine), quaternary ammonium salts (e.g., tetramethylammonium hydroxide, tetraethylammonium hydroxide), and cyclic amines (e.g., pyrrole, piperidine). The above mentioned alkaline aqueous solutions can contain alcohols, surface active agents, aromatic hydroxyl group-containing compounds, etc., in proper amounts. Most preferred among these additives is tetraammonium hydroxide.

The positive type photoresist composition of the present invention is excellent in resolution and less subject to resist pattern breaks due to fine foaming during pattern exposure or scum during development and can be most preferably used for fine work.

The present invention will be further described hereinafter, but the present invention should not be construed as being limited thereto.

PREPARATION EXAMPLES 1 TO 5

Examples of the preparation of novolak resins (a) to (d) and (d') of the present invention will be described hereinafter.

150 g of a mixture of m-cresol and p-cresol in proportions as set forth in Table 1 and 80 g of formalin (37% aqueous solution) were charged into a 1,000-ml three necked flask equipped with an agitator and a reflux condenser. The reaction systems were heated at a temperature of 110°C over an oil bath with vigorous stirring. 3.6 g of zinc acetate dihydrate was then added to each of these reaction systems. The reaction systems were each heated with stirring for 5 hours. 150 g of a mixture of m-cresol and p-cresol in the same proportions as used above and 70 g of formalin were charged into the flask. The reaction systems were each further heated with stirring for 1 hour. The reaction systems were each cooled to a temperature of 80°C. 0.2 g of oxalic acid was added to each of the reaction systems. The reaction systems were each heated under reflux with stirring at a temperature of 110°C over an oil bath for 15 hours to complete the reaction. The contents of the flask were each poured into water containing 1% hydrochloric acid. The reaction products were each extracted with ethyl cellosolve acetate. The reaction systems were each dehydrated at an elevated temperature of 200°C in a vacuum still. The reaction systems were each distilled under a reduced absolute pressure of 2 to 3 mm Hg for 2 hours to remove residual monomers therefrom. Molten polymers were each withdrawn from the flask to obtain desired novolak resins.

These novolak resins were each subjected to structural analysis by $^{13}$C-NMR as specified herein. The results of X value and m-cresol content are set forth in Table 1.

PREPARATION EXAMPLES 6 TO 8

Examples of the preparation of novolak resins (e) to (g) of the present invention will be described hereinafter.

300 g of a mixture of m-cresol and p-cresol in proportions as set forth in Table 1 and 54 g of paraformaldehyde were each charged into a 1,000-ml three necked flask equipped with an agitator and a reflux condenser. 10 g of triethylamine and 300 g of dioxane were added to each of the reaction systems. The reaction systems were each heated at a temperature of 100°C over an oil bath with vigorous stirring for 15 hours. The reaction products were each poured into water containing 1% hydrochloric acid. The resulting precipitates were filtered off. The precipitates were thoroughly washed with 1 liter of methanol, and then dried in a vacuum oven to obtain desired novolak resins.

These novolak resins were each examined for X value and m-cresol content in the same manner as in Preparation Example 1. The results are set forth in Table 1.

## TABLE 1

### Properties of Novolak Resins

| Novolak Resin | m-Cresol: p-Cresol | m Value (%) | X Value |
|---|---|---|---|
| a | 85:15 | 90 | 0.575 |
| b | 75:25 | 81.5 | 0.60 |
| c | 65:35 | 70 | 0.64 |
| d | 40:60 | 50 | 0.75 |
| d' | 25:75 | 35 | 0.86 |
| e | 85:15 | 92 | 0.61 |
| f | 75:25 | 80 | 0.70 |
| g | 65:35 | 67 | 0.75 |
| h | 80:20 | 88 | 0.53 |
| i | 70:30 | 76 | 0.60 |
| j | 60:40 | 67 | 0.695 |
| k | 85:15 | 90 | 0.47 |
| ℓ | 60:40 | 69 | 0.58 |
| m | 40:60 | 48 | 0.68 |
| m' | 25:75 | 38 | 0.73 |

PREPARATION EXAMPLES 9 TO 11

300 g of a mixture of m-cresol and p-cresol in proportions as set forth in Table 3, 65 g of paraformaldehyde and 1,000 g of xylene were each charged into a closed autoclave. The reaction systems were each heated at a temperature of 200°C for 20 hours with stirring. The reaction systems were each cooled to room temperature where they were then put under a reduced pressure of 40 mm Hg. The flask contents were each distilled under a reduced pressure of 2 to 3 mm Hg to remove solvent and unreacted monomers therefrom. Molten polymers were each withdrawn from the flask to obtain desired novolak resins.

These novolak resins were each examined for X value and m-cresol content in the same manner as in Preparation Example 1. The results are set forth in Table 1.

PREPARATION EXAMPLES 12 TO 15

Comparative examples of novolak resins (k) to (m) and (m') which are not according to the present invention will be described hereinafter.

300 g of a mixture of m-cresol and p-cresol in proportions as set forth in Table 1, 158 g of formalin (37% aqueous solution) and 20 ml of 5% aqueous solution of oxalic acid were each charged into a 1,000-ml three necked flask equipped with an agitator and a reflux condenser. The reaction systems were heated at a temperature of 110° C over an oil bath with vigorous stirring for 15 hours. The reflux condenser was then removed from the flask, and the reaction systems were each dehydrated at an elevated temperature of 200° C. The reaction systems were each distilled under a reduced pressure of 2 to 3 mm Hg for 2 hours to remove residual monomers therefrom. Molten polymers were each withdrawn from the flask to obtain desired novolak resins. These novolak resins were each subjected to structural analysis by $^{13}$C-NMR as specified herein. The results of X value and m-cresol content are set forth in Table 1.

PREPARATION EXAMPLE 16

A comparative example of the preparation of novolak resin (n) which is not according to the present invention will be described hereinafter.

300 g of a 7:3 mixture of m-cresol and p-cresol, 162 g of formalin (37% aqueous solution) and 2.4 g of zinc acetate dihydrate were charged into a 1,000-ml three necked flask equipped with an agitator and a reflux condenser. The reaction system was heated at a temperature of 110° C over an oil bath with vigorous stirring for 1 hour. The reaction system was then cooled to a temperature of 80° C where 2.4 g of oxalic acid was added to the reaction system. The reaction system was again heated under reflux with stirring at a temperature of 110° C over an oil bath for 15 hours to complete the reaction. The content of the flask was then poured into water containing 1% hydrochloric acid. The reaction products were then extracted with ethyl cellosolve acetate. The reaction products were dehydrated at an elevated temperature of 200° C in a vacuum still. The reaction products were distilled under a reduced pressure of 2 to 3 mm Hg for 2 hours to remove residual monomers therefrom. Molten polymers were each withdrawn from the flask to obtain the desired novolak resin.

The novolak resin was subjected to structural analysis by $^{13}$C-NMR as specified herein to determine X value and m-cresol content. (m: 80%; X: 0.535)

PREPARATION EXAMPLE 17

A comparative example of the preparation of a novolak (o) which is not according to the present invention will be described hereinafter. A novolak resin (o) was prepared in accordance with Reference Example 1 in JP-A-62-270951.

The structural analysis of the novolak resin (o) thus obtained by $^{13}$C-NMR showed an m value of 48% and an X value of 0.625.

PREPARATION EXAMPLE 18 TO 20

Comparative examples of the preparation of novolaks (p), (p') and (p") which are not according to the present invention will be described hereinafter.

300 g of a mixture of m-cresol and p-cresol in proportions indicated in Table 1', 132 g of formalin (37% aqueous solution) and 4.8 g of zinc acetate dihydrate were charged into a 1,000-ml three necked flask equipped with an agitator and a reflux condenser. The reaction system was heated at a temperature of 110° C over an oil bath with vigorous stirring for 15 hours. The content of the flask was then poured into water containing 1% hydrochloric acid. The reaction products were then extracted with ethyl cellosolve acetate. The reaction products were dehydrated at an elevated temperature of 200° C in a vacuum still. The reaction products were distilled under a reduced pressure of 2 to 3 mm Hg for 2 hours to remove residual monomers therefrom. The resulting molten polymer was withdrawn from the flask to obtain the desired novolak resin.

The novolak resin thus obtained was subjected to structural analysis by $^{13}$C-NMR to determine X value and m-cresol content. The results are shown in Table 1'.

## TABLE 1'

## Properties of Novolak Resins

| Novolak Resin | m-Cresol:p-Cresol | m Value (%) | X Value |
|---|---|---|---|
| p | 80:20 | 88 | 0.85 |
| p' | 25:75 | 37 | 0.92 |
| p" | 5 :95 | 13 | 0.93 |

PREPARATION EXAMPLE 21

A comparative example of the preparation of a novolak resin (q) which is not according to the present invention will be described hereinafter.

150 g of m-cresol which had been obtained by distillation and purification (purity: 99.5%) and 80 g of formalin (37% aqueous aqueous solution) were charged into a 1,000-ml three necked flask equipped with an agitator and a reflux condenser. 3.6 g of zinc acetate dihydrate was added to the reaction system while the latter was heated at a temperature of 110°C over an oil bath with vigorous stirring. The reaction system was then heated at the same temperature with stirring for 5 hours. 150 g of m-cresol and 70 g of formalin as used above were charged into the flask. The reaction system was further heated with stirring for 1 hour. The reaction system was then cooled to a temperature of 80°C where 0.2 g of oxalic acid was added to the reaction system. The reaction system was again heated under reflux with stirring at a temperature of 110°C over an oil bath for 15 hours to complete the reaction. The content of the flask was then poured into water containing 1% hydrochloric acid. The reaction products were then extracted with ethyl cellosolve acetate. The reaction products were dehydrated at an elevated temperature of 200°C in a vacuum still. The reaction products were distilled under a reduced pressure of 2 to 3 mm Hg for 2 hours to remove residual monomers therefrom. The molten polymer was withdrawn from the flask to obtain the desired novolak resin.

The novolak resin thus obtained was subjected to structural analysis by $^{13}$C-NMR to determine X value and m-cresol content. (m: 100%; X: 0.55)

The relationship between these m values and X values is shown in Figure 1.

EXAMPLES 1 TO 10 AND 4' AND COMPARATIVE EXAMPLES 1 TO 7, 6' AND 6"

5 g of each of novolak resins (a) to (j)and (d') (present examples) and (k) to (q), (p') and (p") (comparative examples) thus obtained and 1.35 g of 1,2-naphthoquinonediazide-5-sulfonyl ester of 2,3,4,4'-tetrahydroxybenzophenone (average esterification degree: 85%) were dissolved in 15 g of ethyl cellosolve acetate. The solution was then filtered off through a 0.2-$\mu$m pore microfilter to prepare a photoresist composition. The photoresist composition thus obtained was then coated on a cleaned silicone wafer by means of a spinner, and dried at a temperature of 100°C over a hot plate for 90 seconds to obtain a resist film with a thickness of 1.2 $\mu$m. The photoresist film was exposed to light through a resolving mask with a stepwise gradation in a reduced projection exposure apparatus (g rays; aperture number: 0.48), developed with an aqueous solution of tetramethylammonium hydroxide (TMAH) for 1 minute, washed with water for 30 seconds, and then dried. The finely patterned resist on the wafer was observed under a scanning electron microscope (SEM) to determine the exposure at which the size of the mask is reproduced on the resist pattern.

The concentration of TMAH to be used in the development was adjusted for each resist so that the exposure was generally equal for each resist. The evaluation was effected among these resists.

The resolution is represented by the width of line in the minimum line-and-space pattern separated at the exposure.

For evaluation of scum, SEM was used to observe the degree of residue observed on the removed portion of the pattern. A 4-stage evaluation system was employed.

For evaluation of defects due to fine foaming, SEM was used to observe the degree of pattern breaks after development on the portion exposed at an exposure twice the above mentioned optimum value. A 4-stage evaluation system was similarly used.

The results are set forth in Table 2.

Table 2 shows that all the compositions comprising resins (a) to (j) of the present invention are less subject to defects due to fine foaming and scum while maintaining the same resolution as that of the composition comprising the comparative resins (k) to (q).

## TABLE 2

### Resist Formation and Evaluation

| Example No. | Novolak Resin Used | TMAH Concentration in Developer (wt%) | Relative Exposure | Resolution | Fine Foaming | Scum |
|---|---|---|---|---|---|---|
| Example 1 | a | 2.4 | 1.0 | 0.6 | b | b |
| Example 2 | b | 2.4 | 0.9 | 0.6 | a | b |
| Example 3 | c | 2.4 | 1.0 | 0.6 | a | a |
| Example 4 | d | 2.8 | 1.4 | 0.5 | a | a |
| Example 4' | d' | 3.2 | 1.4 | 0.6 | b | b |
| Example 5 | e | 2.4 | 1.2 | 0.6 | b | b |
| Example 6 | f | 2.8 | 0.8 | 0.6 | a | b |
| Example 7 | g | 2.8 | 1.4 | 0.6 | a | a |
| Example 8 | h | 2.2 | 0.8 | 0.6 | b | b |
| Example 9 | i | 2.4 | 0.9 | 0.6 | a | b |
| Example 10 | j | 2.8 | 1.1 | 0.5 | a | a |
| Comparative Example 1 | k | 1.5 | 1.0 | 0.7 | c | c |
| Comparative Example 2 | ℓ | 1.9 | 1.2 | 0.6 | c | c |
| Comparative Example 3 | m | 2.4 | 1.1 | 0.5 | b | d |
| Comparative Example 4 | n | 1.9 | 0.8 | 0.6 | d | c |
| Comparative Example 5 | o | 2.2 | 0.9 | 0.6 | b | d |

TABLE 2 (cont'd)

| Example No. | Novolak Resin Used | TMAH Concentration in Developer (wt%) | Relative Exposure | Resolution | Fine Foaming | Scum |
|---|---|---|---|---|---|---|
| Comparative Example 6 | p | 3.8 | 1.4 | 0.6 | d | b |
| Comparative Example 6' | p' | 3.8 | 1.8 | 0.7 | c | d |
| Comparative Example 6" | p" | 3.8 | 2.0 | 0.7 | c | d |
| Comparative Example 7 | q | 2.4 | 0.9 | 0.6 | c | c |

Relative exposure: Relative value of exposure ($mJ/cm^2$) required to

enable a 1:1 reproduction of mask pattern

Fine foaming: (poor) d<c<b<a (excellent)

Scum: (poor) d<c<b<a (excellent)


EXAMPLES 11 TO 13 AND COMPARATIVE EXAMPLES 8 TO 10

An experiment was conducted in the same manner as in Example 1 except that resins (c) and (m) were used and as light-sensitive material to be used in combination therewith were 1,2-naphthoquinonediazide-5-sulfonyl ester of 3,3,3',3'-tetramethyl-1,1'-spirobi-indan-5,6,7,5',6',7'-hexol (average esterification degree: 65%) used in amounts as set forth in Table 3.

The results are set forth in Table 3.

Table 3 shows that all the compositions comprising resin (c) of the present invention are less subject to defects due to fine foaming and scum while maintaining the same resolution as that of the composition comprising the comparative resin (m).

T A B L E   3

Resist Formulation and Evaluation

| Example No. | Novolak Resin Used | Added Amount of Light-Sensitive Material (wt%)* | TMAH Concentration in Developer (wt%) | Relative Exposure | Resolution | Fine Foaming | Scum |
|---|---|---|---|---|---|---|---|
| Example 11 | c | 10 | 1.8 | 0.8 | 0.6 | a | a |
| Example 12 | c | 20 | 2.4 | 1.1 | 0.6 | a | a |
| Example 13 | c | 30 | 3.6 | 1.0 | 0.5 | a | b |
| Comparative Example 8 | m | 10 | 1.8 | 0.9 | 0.6 | c | c |
| Comparative Example 9 | m | 20 | 2.4 | 1.2 | 0.5 | b | d |
| Comparative Example 10 | m | 30 | 3.6 | 1.1 | 0.6 | c | d |

*: Weight % based on the total solid content

EXAMPLES 14 TO 18 AND COMPARATIVE EXAMPLES 11 AND 12

An experiment was conducted in the same manner as in Example 1 except that resin (a), (c) or (q) was used and the type of the light-sensitive material to be used in combination therewith was altered as set forth in Table 4.

The results are set forth in Table 4.

Table 4 shows that regardless of light-sensitive material to be combined the compositions comprising resin (a) or (c) of the present invention are less subject to defects due to fine foaming and scum while maintaining the same resolution as that of the compositions comprising the comparative resin (q).

T A B L E 4

Resist Formulation and Evaluation

| Example No. | Novolak Resin Used | Type of Light-Sensitive Material** | TMAH Concentration in Developer (wt%) | Relative Exposure | Resolution | Fine Foaming | Scum |
|---|---|---|---|---|---|---|---|
| Example 14 | a | r | 2.3 | 0.8 | 0.6 | b | a |
| Example 15 | a | s | 2.5 | 0.9 | 0.6 | a | a |
| Example 16 | c | t | 2.2 | 1.2 | 0.6 | a | b |
| Example 17 | c | u | 1.9 | 1.0 | 0.5 | a | a |
| Example 18 | c | v | 2.4 | 1.2 | 0.5 | a | a |
| Comparative Example 11 | q | s | 2.5 | 1.0 | 0.6 | c | c |
| Comparative Example 12 | q | t | 2.2 | 1.1 | 0.6 | c | d |

**: 1,2-Naphthoquinonediazido-5-sulfonyl ester of the following polyhydroxy compounds:

r: 2,3,4-Trihydroxybenzophenone (average esterification degree: 90%)

s: 4,4',3",4"-Tetrahydroxy-3,5,3',5'-tetramethyl triphenylmethane (average esterification degree: 70%)

t: Phloroglucinol (average esterification degree: 100%)

u: Ortho-cresol resin with a weight average molecular weight of about 5,000 (average esterification degree: 50%)

v: 2,6-Bis(3,5-dimethyl-4-hydroxybenzyl)-4-methylphenol (average esterification degree: 100%)

While the invention has been described in detail and with reference to specific embodiments thereof, it will be apparent to one skilled in the art that various changes and modifications can be made therein without departing from the spirit and scope thereof.

**Claims**

1. A positive type photoresist composition comprising an alkali-soluble novolak resin and a 1,2-quinonediazide compound, wherein said novolak resin is a condensate of a mixture of m-cresol and p-cresol with at least one of formaldehyde, formaldehyde polymer and formlaldehyde precursor and wherein the relationship between X = A/(A+B+C) and the content of m-cresol in said novolak resin falls within the shaded part (including the straight lines surrounding this part) in Figure 1, said A representing an integrated value of peak area between 23.0 ppm and 31.0 ppm , B representing an integrated value of peak area between 31.0 ppm and 34.0 ppm and C representing an integrated value of peak area between 34.0 ppm and 37.0 ppm in a $^{13}$C-NMR spectrum of a dimethyl sulfoxide-$d_6$ solution of said novolak resin.

2. A positive type photoresist composition as in claim 1, wherein the proportion of m-cresol is 20 to 95% based on the total of m-cresol and p-cresol.

3. A positive type photoresist composition as in claim 2, wherein the proportion of m-cresol is 40 to 85% based on the total of m-cresol and p-cresol.

4. A positive type photoresist composition as in claim 3, wherein the proportion of m-cresol is 40 to 75% based on the total of m-cresol and p-cresol.

5. A positive type photoresist composition as in any one of claims 1-4, wherein the average molecular weight of the novolak resin, as determined by gel permeation chromatography, is within the range of 1,000 to 30,000 as calculated in terms of polystyrene.

6. A positive type photoresist composition as in claim 5, wherein the average molecular weight of the novolak resin, as determined by gel permeation chromatography, is within the range of 2,000 to 15,000, as calculated in terms of polystyrene.

7. A positive type photoresist composition as in any one of claims 1-6, wherein the dimer content is less than 15% by weight of the novolak resin.

8. A method for prevention of pattern break in a positive type photoresist composition comprising an alkali-soluble novolak resin and a 1,2-quinonediazide compound, said method comprising condensing a mixture of m-cresol and p-cresol with at least one of formaldehyde, formaldehyde polymer and formaldehyde precursor such that the relationship between $X = A/(A+B+C)$ and the content of m-cresol in said novolak resin falls within the shaded part (including the straight lines surrounding this part) in Figure 1, said A representing an integrated value of peak area between 23.0 ppm and 31.0 ppm, B representing an integrated value of peak area between 31.0 ppm and 34.0 ppm and C representing an integrated value of peak area between 34.0 ppm and 37.0 ppm in a $^{13}$C-NMR spectrum of a dimethyl sulfoxide-d$_6$ solution of said novolak resin, coating the photoresist onto a support, imagewise exposing the photoresist, and developing to remove exposed portions of the photoresist.

Fig. 1

m (% m-cresol content)

Fig. 2